# EUROPÄISCHE PATENTSCHRIFT

(11) **EP 3 440 687 B1**
(45) Veröffentlichungstag und Bekanntmachung des Hinweises auf die Patenterteilung: **21.10.2020**
(21) Anmeldenummer: 17711176.2
(22) Anmeldetag: 16.03.2017
(51) Int. Cl.: H01H 9/54, H01H 33/04, H01H 33/59

(54) **SCHALTVORRICHTUNG ZUM FÜHREN UND TRENNEN VON ELEKTRISCHEN STRÖMEN**
SWITCHING DEVICE FOR CONDUCTING AND INTERRUPTING ELECTRICAL CURRENTS
DISPOSITIF DE COMMUTATION POUR ACHEMINER ET COUPER DES COURANTS ÉLECTRIQUES

(30) Priorität: 07.04.2016 DE 102016106414
(43) Veröffentlichungstag der Anmeldung: 13.02.2019
(73) Patentinhaber: Eaton Intelligent Power Limited, Dublin 4 (IE)
(72) Erfinder: SCHMITZ, Gerd, 53859 Niederkassel (DE); MEISSNER, Johannes, 53129 Bonn (DE); UEDELHOVEN, Marcel, 53945 Blankenheim (DE); WOHLANG, Michael, 53332 Bornheim (DE); KREFT, Oliver, 53119 Bonn (DE)
(74) Vertreter: Eaton IP Group EMEA
(86) Internationale Anmeldenummer: PCT/EP2017/056319
(87) Internationale Veröffentlichungsnummer: WO 2017/174328

(56) Entgegenhaltungen:
- DE-A1-102013 114 259
- US-A- 4 356 525
- US-B1- 6 643 112

## Beschreibung

Die Erfindung betrifft eine Schaltvorrichtung zum Führen und Trennen von elektrischen Strömen, insbesondere eine Hybridschaltanordnung zum Führen und Trennen hoher DC-Ströme und niederfrequenter AC-Ströme, und ein Schaltgerät mit einer derartigen Schaltvorrichtung.

In der der deutschen Offenlegungsschrift DE 10 2013 114 259 A1 ist eine vorteilhafte Variante einer Hybridschaltanordnung beschrieben, bei der die Strombelastung des Leistungshalbleiters zur Erzielung einer möglichst hohen Lebenserwartung sowie einer möglichst geringen Dimensionierung zeitlich minimiert ist, was vor allem bei Leistungsschützen im Strombereich einiger hundert Ampere wichtig ist. Zur zeitlichen Minimierung des durch den Leistungshalbleiter fließenden Laststroms wird über einen Stromwandler der Kommutierungszeitpunkt erfasst und der Stromfluss durch den Halbleiter nur so lange aufrechterhalten, bis die sich öffnende mechanische Schaltstrecke eine ausreichende elektrische Festigkeit erreicht hat. In dieser kurzen Zeit wird der Laststrom durch den Halbleiter über dessen Ansteuerung künstlich zu Null geführt, so daß nach Öffnen sowohl der Löschkontakt- als auch der hierzu in Reihe geschalteten Trennkontaktanordnung eine sichere galvanische Trennung erzielt wird.

Bei der Auslegung eines Schaltgeräts besteht eine wichtige Aufgabe darin, zur Gewährleistung der Funktionssicherheit sowie zur Erzielung einer hohen elektrischen Lebensdauer ein Verschweißen der Schaltkontakte zu verhindern. Auch bei Verwendung eines geeigneten Kontaktwerkstoffs sowie ausreichender Kontaktgröße besteht v.a. bei Schaltgeräten für Ströme im Bereich einiger hundert Ampere, wofür vergleichsweise hohe Kontaktdruckkräfte erforderlich sind, prinzipiell die Gefahr, dass es bei der Kontaktgabe während des Einschaltvorgangs zu einem kurzen Rückprellen der Kontakte kommt. Bei einem solchen Prellvorgang kommt es zwischen den minimal geöffneten Kontakten kurzzeitig zur Ausbildung eines Lichtbogens. Insbesondere bei hohen Bogenströmen kann es dabei im Bereich der Fußpunkte zu lokalen Aufschmelzungen der Kontaktoberflächen kommen, welche bei der unmittelbar nachfolgenden erneuten Kontaktierung dann zu einer Verschweißung der beiden Kontakte führt. Die Neigung zum Verschweißen steigt hierbei insbesondere bei solchen Kontakten, deren Oberflächen durch zahlreiche lichtbogenbehaftete Schalthandlungen bereits eine stark veränderte Topografie aufweisen. Hier kommt es vorzugsweise im Bereich von Kontaktspitzen zu punktuellen Verschweißungen. Gelingt es beim nachfolgenden Ausschaltvorgang nicht, eine solche Verschweißung mit Hilfe des Schaltantriebs wieder aufzubrechen, ist das Schaltgerät nicht mehr funktionstüchtig. Dies gilt grundsätzlich auch für Hybridschalter. Kommt es beispielsweise beim Einschalten der in der deutschen Offenlegungsschrift DE 10 2013 114 259 A1 beschriebenen Hybrid-Schaltanordnung zu einer Verschweißung der sog. Löschkontakte, kann es beim nachfolgenden Ausschaltvorgang nicht mehr zu einer Kommutierung auf den Leistungshalbleiter kommen, welche durch das mechanische Öffnen der Löschkontakte ermöglicht wird. Durch Ausbleiben der Kommutierung des Laststroms auf den IGBT, verliert der Hybridschalter seine Grundfunktion, durch kurzzeitiges Führen des Laststroms durch den Halbleiter diesen dort zu Null zu führen. Beim Öffnen der für die galvanische Trennung des Hybridschalters zuständigen zweiten mechanischen Kontaktanordnung kann es dann zur Ausbildung eines dauerhaften Lichtbogens und damit zur Zerstörung des Schaltgeräts kommen.

Die US-Patentschrift US 3,639,808 beschreibt eine Schutzschaltung für einen Schaltkontakt eines Relais, die einen parallel zu dem Schaltkontakt geschalteten Triac aufweist, der vor dem Schließen und nach dem Öffnen des Schaltkontakts für ein kurzes Zeitintervall durchgeschaltet wird, um die Ausbildung eines Lichtbogens am Schaltkontakt zu vermeiden. Insbesondere wird der Triac laut der US-Patentschrift US 3,639,808 ca. 5-15 Millisekunden vor dem Schließen des Schaltkontakts durchgeschaltet. Dies kann jedoch bei sehr großen zu schaltenden Strömen zu einer erheblichen Belastung des Triacs und einer damit einhergehenden Lebensreduzierung führen.

Hybridschaltanordnungen sind zudem aus den US-Patentschriften 6,643,112 und 4,365,525 bekannt.

Aufgabe der vorliegenden Erfindung ist es daher, eine Schaltvorrichtung zum Führen und Trennen von elektrischen Strömen, insbesondere eine verbesserte Hybridschaltanordnung zum Führen und Trennen hoher DC-Ströme und niederfrequenter AC-Ströme, und ein verbessertes Schaltgerät mit einer derartigen Schaltvorrichtung vorzuschlagen, bei denen die Gefahr des Ausbildens ungewollter Schaltlichtbögen reduziert ist und dadurch eine erhöhte Funktionssicherheit sowie eine möglichst hohe elektrische Lebensdauer erzielt werden kann.

Diese Aufgabe wird durch die Gegenstände der unabhängigen Ansprüche gelöst. Weitere Ausgestaltungen der Erfindung sind Gegenstand der abhängigen Ansprüche.

Die vorliegende Erfindung schlägt vor, einen Hybridschalter wie den eingangs geschilderten und aus der deutschen Offenlegungsschrift DE 10 2013 114 259 A1 bekannten Schalter derart zu modifizieren, dass wie bei der aus der US-Patentschrift US 3,639,808 bekannten Schutzschaltung bei einem Schließvorgang einer mechanischen Kontaktanordnung ein parallel zu dieser geschalteter Halbleiterschalter wenigstens kurzzeitig angeschaltet bzw. durchgeschaltet wird, um eine zeitlich begrenzte Kommutierung des mit der mechanischen Kontaktierung einsetzenden Stromflusses auf den Halbleiterschalter zu bewirken und so Einschaltlichtbögen zu unterdrücken, die durch ein Prellen des mechanischen Kontaktanordnung auftreten können. Im Idealfall erfahren die Kontakte beim Einschaltvorgang keine prellbedingte Lichtbogenbelastung mehr. Um die Strombelastung des Halbleiterschalters so gering wie möglich zu halten, sieht die Erfindung vor, dass nach Initialisierung einer Schaltelektronik zum Steuern des Halbleiterschalters eine vorgegebene Zeitdauer gewartet wird, bis der Halbleiterschalter angeschaltet wird, und die vorgegebene Zeitdauer abhängig von der mechanischen Kontaktanordnung eingestellt wird, so dass sie an die mechanische Kontaktanordnung angepasst ist. Dies ermöglicht es, den Kommutierungszeitpunkt des Stromflusses auf den Halbleiterschalter so nahe an den Kontaktierungszeitpunkt der mechanischen Kontaktanordnung zu verlegen, dass eine zu starke Strombelastung des Halbleiterschalters und eine dadurch unter Umständen verursachte Lebensdauerreduzierung vermieden werden kann.

Eine Ausführungsform der Erfindung betrifft nun eine Schaltvorrichtung zum Führen und Trennen von elektrischen Strömen mit einer ersten mechanischen Kontaktanordnung, einem Halbleiterschalter, der parallel zur ersten mechanischen Kontaktanordnung geschaltet ist, einer zweiten mechanischen Kontaktanordnung, die in Reihe zur ersten mechanischen Kontaktanordnung geschaltet ist, und einer Schaltelektronik, die zum An- und Abschalten des Halbleiterschalters ausgebildet ist. Erfindungsgemäß ist die Schaltelektronik ausgebildet, während eines Schließvorgangs der ersten mechanischen Kontaktanordnung den Halbleiterschalter nach Ablauf einer ersten vorgegebenen Zeitdauer t-0 nach Initialisierung der Schaltelektronik anzuschalten und nach Ablauf einer zweiten vorgegebenen Zeitdauer t-1 wieder auszuschalten, wobei die erste vorgegebene Zeitdauer t-0 von der Schaltelektronik abhängig von der ersten mechanischen Kontaktanordnung eingestellt wird.

Um die Kommutierung des Stromflusses auf den Halbleiterschalter noch besser an die erste mechanische Kontaktanordnung anzupassen, kann die Schaltelektronik ferner ausgebildet sein, die zweite vorgegebene Zeitdauer t-1 abhängig von der ersten mechanischen Kontaktanordnung einzustellen. Beispielsweise kann die Zeitdauer t-1 auf eine Zeitdauer eingestellt werden, die so bemessen ist, dass die Kontakte der ersten mechanischen Kontaktanordnung sicher geschlossen sind und kein Einschaltprellen mehr auftritt, so dass eine prellbedingte Lichtbogenbelastung der Kontakte weitgehend vermieden wird, die Belastungszeit des Halbleiterschalters durch den kommutierten Stromfluss zudem so kurz wie möglich ist.

Weiterhin kann die Schaltelektronik ausgebildet sein, nach Initialisierung der Schaltelektronik Daten zur ersten mechanischen Kontaktanordnung zu empfangen und abhängig von den empfangenen Daten die erste vorgegebene Zeitdauer t-0 und/oder die zweite vorgegebene Zeitdauer t-1 einzustellen. Diese Daten können beispielsweise Kennwerte der mechanischen Kontaktanordnung umfassen, wie beispielsweise typische Zeitdauern bis zu einem ersten Schließen der Kontakte unter Berücksichtigung einer Trägheit der Kontaktanordnung. Die Daten können digital und/oder analog empfangen werden, beispielsweise in Form von digitalen Daten oder von analogen Messwerten.

Beispielsweise kann die Schaltelektronik ausgebildet sein, Daten zur ersten mechanischen Kontaktanordnung zu empfangen, indem sie den Spannungsabfall an einem der ersten mechanischen Kontaktanordnung zugeordneten elektrischen Widerstand misst, den Messwert in einem Register als Kennwert speichert, anhand des Kennwerts und einer Wertetabelle mit Eigenschaften verschiedener mechanischer Kontaktanordnungen eine für die erste mechanische Kontaktanordnung passende Sperrzeit für den Halbleiterschalter ermittelt und die erste vorgegebene Zeitdauer t-0 abhängig von der ermittelten Sperrzeit einstellt. In diesem Fall sind Daten zur mechanischen Kontaktanordnung analog in Form des elektrischen Widerstands kodiert, der typenspezifisch verschieden ausfallen und an irgendeiner Stelle integriert in einem Schaltgerät angeordnet sein kann. Die Speisung des elektrischen Widerstands mit einem Strom zum Erzeugen des gewünschten Spannungsabfalls kann durch die Schaltelektronik selbst oder auch durch eine externe Schaltung erfolgen. Beispielsweise kann die Schaltelektronik unmittelbar nach ihrer Initialisierung den elektrischen Widerstand bestromen und die dadurch an ihm abfallende Spannung messen. Der elektrische Widerstand kann aber auch durch einen die Schaltvorrichtung speisenden Strom versorgt werden, und die Schaltelektronik kann die an ihm abfallende Spannung nach ihrer Initialisierung messen. Die Messung des Spannungsabfalls am elektrischen Weiderstand kann beispielsweise über eine entsprechende Kabelverbindung erfolgen, welche entweder bei der Montage der Schaltvorrichtung in einem Schaltgeräts angebracht wird, oder auch über eine Pin-Kontaktierung, welche z.B. bei der Assemblierung zweier Gehäuseteile des Schaltgeräts automatisch erfolgt.

Die Schaltelektronik kann auch ausgebildet sein, Daten zur ersten mechanischen Kontaktanordnung zu empfangen, indem sie ein drahtloses Lesegerät aktiviert, mit dem aktivierten Lesegerät in einem der ersten mechanischen Kontaktanordnung zugeordneten Transponder gespeicherte Daten ausliest, die ausgelesenen Daten in einem Register als Kennwert speichert, anhand des Kennwerts und einer Wertetabelle mit Eigenschaften verschiedener mechanischer Kontaktanordnungen eine für die erste mechanische Kontaktanordnung passende Sperrzeit für den Halbleiterschalter ermittelt und die erste vorgegebene Zeitdauer t-0 abhängig von der ermittelten Sperrzeit einstellt. Als Transponder kann beispielsweise ein RFID (Radio Frequency Identification)-Chip, insbesondere gemäß dem NFC (Near Field Communication)-Standard (ISO 14443, 18092, 21481 ECMA 340, 352, 356, 362, ETSI TS 102 190), insbesondere in einem Gehäuse der ersten mechanischen Kontaktanordnung eingesetzt werden, der Daten zur ersten mechanischen Kontaktanordnung speichert. Das drahtlose Lesegerät kann beispielsweise als Teil der Schaltelektronik ausgebildet sein, das nach erfolgter Einschaltinitialisierung der Schaltelektronik magnetische Wechselfelder aussendet, welche den Transponder (-Chip) zunächst mit Energie versorgen und ihn dann zur Emission seiner individuellen Kennung anregen, welche von der Schaltelektronik gelesen wird.

Weiterhin kann die Schaltelektronik ausgebildet sein, anhand des Kennwerts und der Wertetabelle mit Eigenschaften verschiedener mechanischer Kontaktanordnungen eine für die erste mechanische Kontaktanordnung passende Kommutierungszeit zu ermitteln und die zweite vorgegebene Zeitdauer t-1 abhängig von der ermittelten Kommutierungszeit einzustellen.

Eine weitere Ausführungsform der Erfindung betrifft ein Schaltgerät mit einer Schaltvorrichtung nach der Erfindung und wie hierin beschrieben und einem Schaltantrieb zum Bewegen von Kontakten der ersten und zweiten mechanischen Kontaktanordnung.

Eine weitere Ausführungsform der Erfindung betrifft ein Gehäuse für ein Schaltgerät nach der Erfindung und wie hierin beschrieben, das mindestens ein elektronisches Bauelement und/oder elektrische Kontaktmittel aufweist, das bzw. die vorgesehen sind, um von einer Schaltelektronik einer Schaltvorrichtung des Schaltergeräts zum Einstellen der ersten vorgegebenen Zeitdauer t-0 verwendet zu werden.

Schließlich betrifft eine Ausführungsform der Erfindung ein Verfahren zum Steuern eines Halbleiterschalters einer Schaltvorrichtung zum Führen und Trennen von elektrischen Strömen, die eine erste mechanische Kontaktanordnung, den Halbleiterschalter, der parallel zur ersten mechanischen Kontaktanordnung geschaltet ist, und eine zweite mechanische Kontaktanordnung aufweist, die in Reihe zur ersten mechanischen Kontaktanordnung geschaltet ist, wobei bei dem Verfahren der Halbleiterschalter während eines Schließvorgangs der ersten mechanischen Kontaktanordnung nach Ablauf einer ersten vorgegebenen Zeitdauer t-0 nach Initialisierung einer zum An- und Abschalten des Halbleiterschalters ausgebildeten Schaltelektronik angeschaltet und nach Ablauf einer zweiten vorgegebenen Zeitdauer t-1 wieder ausgeschaltet wird, wobei die erste vorgegebene Zeitdauer t-0 von der Schaltelektronik abhängig von der ersten mechanischen Kontaktanordnung eingestellt wird.

Das Verfahren kann von einer zum An- und Abschalten des Halbleiterschalters ausgebildeten Schaltelektronik ausgeführt werden. Insbesondere kann die Schaltelektronik durch einen Prozessor und einen Speicher implementiert sein, in dem ein Programm gespeichert ist, das den Prozessor zum Ausführen eines Verfahrens nach der Erfindung und wie hierin beschrieben konfiguriert.

Weitere Vorteile und Anwendungsmöglichkeiten der vorliegenden Erfindung ergeben sich aus der nachfolgenden Beschreibung in Verbindung mit den in den Zeichnungen dargestellten Ausführungsbeispielen.

In der Beschreibung, in den Ansprüchen, in der Zusammenfassung und in den Zeichnungen werden die in der hinten angeführten Liste der Bezugszeichen verwendeten Begriffe und zugeordneten Bezugszeichen verwendet.

Die Zeichnungen zeigen in
Fig. 1 ein Blockschaltbild eines Ausführungsbeispiels einer Schaltvorrichtung mit einer Doppelkontaktanordnung gemäß der Erfindung; und
Fig. 2-5 Ablaufdiagramme verschiedener Ausführungsbeispiele der Steuerung eines Halbleiterschalters durch eine Schaltelektronik einer Schaltvorrichtung gemäß der Erfindung.

In der folgenden Beschreibung können gleiche, funktional gleiche und funktional zusammenhängende Elemente mit den gleichen Bezugszeichen versehen sein. Absolute Werte sind im Folgenden nur beispielhaft angegeben und sind nicht als die Erfindung einschränkend zu verstehen.

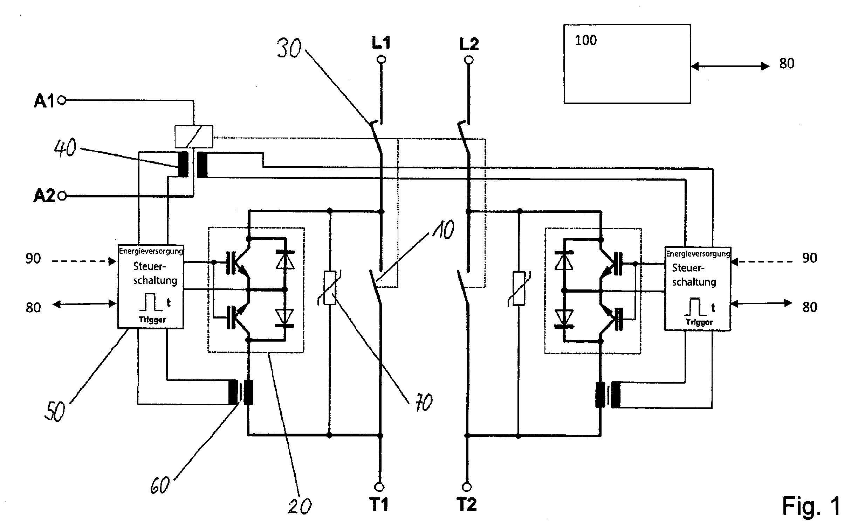

Fig. 1 zeigt das Blockschaltbild einer erfindungsgemäßen Schaltvorrichtung für ein 2-poliges, polaritätsunabhängiges Schaltgerät. Die Anschlüsse des Schaltgeräts für die beiden Pole sind jeweils mit L1, T-1 und L2, T2 bezeichnet. Diese Schaltvorrichtung entspricht schaltungstechnisch weitgehend der in der deutschen Offenlegungsschrift DE 10 2013 114 259 A1 beschriebenen und darin in Fig. 1 gezeigten Vorrichtung. Von dieser bekannten Vorrichtung unterscheidet sich die nachfolgend beschriebene erfinderische Vorrichtung in der Schaltelektronik 50, die für eine spezielle Ansteuerung des Halbleiterschalters 20 ausgebildet ist, wie in der nachfolgenden Beschreibung noch im Detail erläutert wird. Die Schaltelektronik 50 kann beispielsweise durch einen Prozessor und einen Speicher implementiert sein (insbesondere einen Mikrokontroller), wobei in dem Speicher ein Programm gespeichert ist, das den Prozessor zum Ausführen von Verfahrensschritten konfiguriert, welche die spezielle Ansteuerung des Halbleiterschalters 20 wie nachfolgend beispielhaft erläutert durch den Prozessor bewirken. Das Programm kann beispielsweise Teil der Firmware eines Prozessor-gesteuerten Schaltgeräts sein.

Für jeden Pol weist die in Fig. 1 gezeigte Schaltvorrichtung eine Parallelschaltung einer ersten mechanischen (Lösch-)Kontaktanordnung 10 mit einem Halbleiterschalter 20 auf Basis einer antiseriellen IGBT-Anordnung (Leistungshalbleiter) auf, welche mit einer zweiten mechanischen Kontaktanordnung 30 zur Sicherstellung der galvanischen Trennung in Serie geschaltet ist. Die mechanischen Kontaktanordnungen 10 und 30 können als Brückenschaltanordnung eines Luftschaltgeräts bzw. -anordnung ausgebildet sein.

Der Halbleiterschalter 20 wird von der Schaltelektronik 50 an- oder abgeschaltet, d.h. durchgesteuert oder gesperrt. Die Schaltelektronik 50 wird von einer in der (Magnetantriebs-)Spule des Schalt- bzw. Magnetantriebs des Schaltgeräts gespeicherten Energie versorgt. Hierzu ist eine galvanisch vom Stromkreis des Schaltantriebs getrennte Hilfsspule 40 vorgesehen, welche beim Abschalten des Schaltantriebs eine Spannung zum Versorgen der Schaltelektronik 50 erzeugen kann. Die Hilfsspule 40 kann beispielsweise um die Antriebsspule gewickelt sein. Zusätzlich oder auch alternativ kann die Schaltelektronik 50 durch eine (nicht dargestellte) externe elektrische Energiequelle versorgt werden (externe Versorgung 90), beispielsweise von einer zentralen Energiequelle für die elektrischen Einheiten eines Schaltschranks oder über ein Bussystem, an das mehrere Schaltvorrichtungen gekoppelt sind, und dergleichen.

Im eingeschalteten Fall, d.h. wenn der Schaltantrieb die Magnetantriebs-Spule mit einer Spannung und einem Strom versorgt und die Kontakte der ersten und zweiten mechanischen Kontaktanordnungen 10 und 30 geschlossen sind, ist der Halbleiterschalter 20 gesperrt, da in diesem Zustand von der Hilfsspule 40 keine Spannung zum Versorgen der Schaltelektronik 50 erzeugt wird und die Schaltelektronik 50 daher spannungslos ist und die IGBTs des Halbleiterschalters 20 nicht ansteuern kann.

Im Moment des Einschaltens der Spannungs- und Stromversorgung der Magnetantriebs-Spule des Schaltantriebs zum Schließen der Kontakte der ersten und zweiten mechanischen Kontaktanordnungen 10 und 30 wird in der Magnetantriebs-Spule Energie gespeichert. Durch den Spulenstrom wird in der elektromagnetisch mit der Magnetantriebs-Spule gekoppelten Hilfsspule 40 eine Spannung induziert, welche die Schaltelektronik 50 aktiviert.

Die in der Hilfsspule 40 induzierte Spannung reicht aus, um zum einen die Schaltelektronik 50 selbst zu versorgen, zum anderen um die zum Ansteuern der IGBTs erforderliche Spannung aufzubauen. Die Hilfsspule 40 bietet den Vorteil, dass die Ansteuerung des Halbleiterschalters bereits vor Schließen der Kontakte der ersten und zweiten mechanischen Kontaktanordnungen 10 bzw. 30 aufgrund der mechanischen Trägheit erfolgen kann.

Im Moment des Einschaltens der Spannungs- und Stromversorgung der Magnetantriebs-Spule des Schaltantriebs zum Schließen der Kontakte der ersten und zweiten mechanischen Kontaktanordnungen 10 und 30 kann auch die externe Versorgung 90 aktiviert werden, um die Schaltelektronik 50 zu aktivieren.

Mit der Aktivierung der Schaltelektronik 50 startet ein Initialisierungsvorgang. Nach Abschluss des Initialisierungsvorgangs werden die IGBTs des Halbleiterschalters 20 zunächst für eine definierte Zeit t-0 gesperrt. Hierdurch wird sichergestellt, dass das Zeitintervall, in welchem sich die IGBTs im durchgeschalteten Zustand befinden, nicht bereits vor der mechanischen Kontaktgabe der ersten mechanischen Kontaktanordnung 10 liegen. Bei Schaltgeräten für Ströme von einigen hundert Ampere ist die Trägheit der mechanischen Schaltanordnung vergleichsweise hoch, so dass die Zeit zwischen dem Einschalten des Spulenstroms für den Schaltantrieb und dem Schließen der Schaltkontakte typischerweise im Bereich von rd. 10 ms liegt. Die Zeit für die Initialisierung der Schaltelektronik 50 und das Durchschalten der IGBTs des Halbleiterschalters 20 ist dagegen erheblich kürzer. Die Wartezeit t-0 ist daher so bemessen, dass der IGBT erst kurz vor der mechanischen Kontaktgabe - unter Mitberücksichtigung gerätespezifischer zeitlicher Toleranzen - durchgeschaltet wird. Kommt es nach der ersten Kontaktierung dann zu einem Rückprellen der Löschkontakte, erfolgt sofort eine Kommutierung des Laststroms auf den Halbleiterschalter 20. Diese Kommutierungszeit t-1 ist dabei so bemessen, dass die IGBTs zur Minimierung der thermischen Belastung sofort in den Sperrzustand überführt werden, sobald die Phase des Einschaltprellens abgeschlossen ist. Eine erneute Ansteuerung des Halbleiterschalters 20 ist dann erst wieder im Zuge der Initialisierung eines regulären Ausschaltvorgangs vorgesehen.

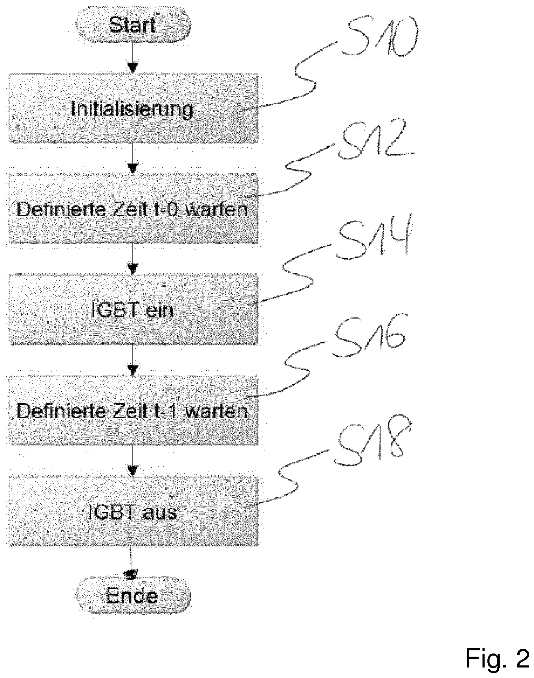

Der schematische grundlegende Steuerungsablauf zur Sicherstellung eines lichtbogenfreien Einschaltprellens ist in Fig. 2 dargestellt: in Schritt S10 erfolgt die Initialisierung der Schaltelektronik 50; in Schritt S12 wartet die Schaltelektronik 50 eine erste vorgegebene Zeitdauer t-0 ab, während der der Halbleiterschalter 20 durch die Schaltelektronik 50 abgeschaltet ist; in Schritt S14 schaltet die Schaltelektronik 50 den Halbleiterschalter 20 an; in Schritt S16 wartet die Schaltelektronik 50 eine zweite vorgegebene Zeitdauer t-1 ab, während der der Halbleiterschalter 20 durch die Schaltelektronik 50 angeschaltet ist; in Schritt S18 schaltet die Schaltelektronik 50 den Halbleiterschalter 20 wieder aus.

Um das so beschriebene lichtbogenfreie Einschalten für unterschiedliche Hybridschalter mit einer einheitlichen Ausführung der Ansteuerelektronik realisieren zu können, was im Hinblick auf die Reduzierung der Variantenvielfalt sowie der Herstellkosten von Vorteil ist, ist nun erfindungsgemäß vorgesehen, die erste vorgegebene Zeitdauer t-0 durch die Schaltelektronik 50 abhängig von der ersten mechanischen Kontaktanordnung 10 einzustellen. Hierzu kann der Schaltelektronik 50 während der Initialisierungsphase der Typ des verwendeten Hybridschalters "mitgeteit" werden, indem die Schaltelektronik 50 eine Gerätekennung mit Daten 80 zur ersten mechanischen Kontaktanordnung 10 empfängt, die zum Einstellen der ersten vorgegebenen Zeitdauer t-1 ausgewertet werden.

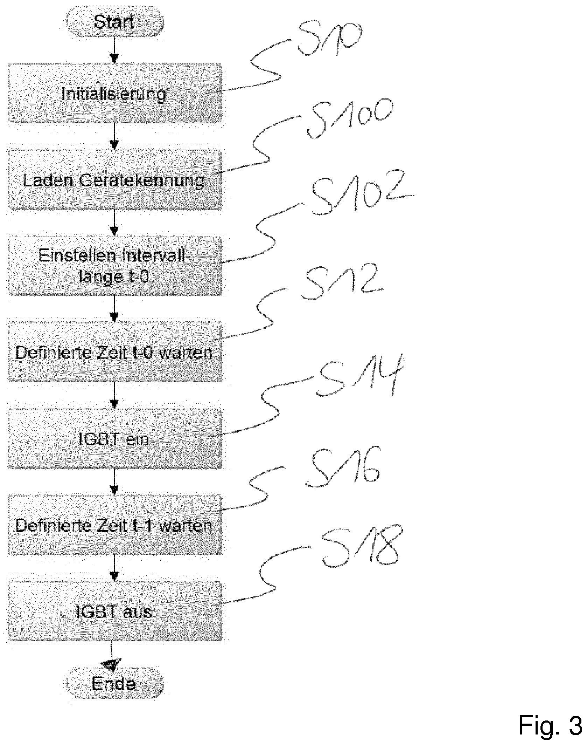

Der schematische grundlegende Steuerungsablauf einer solchen Einschaltsteuerung mit integrierter Erkennung des Gerätetyps ist in der Fig. 3 dargestellt: in Schritt S10 erfolgt die Initialisierung der Schaltelektronik 50; in Schritt S100 wird die Gerätekennung geladen; im Schritt S102 wird die vorgegebene Zeitdauer t-0 abhängig von der geladenen Gerätekennung eingestellt; die Schritte S12 bis S18 entsprechen den gleichnummerierten Schritten im Ablaufdiagramm der Fig. 2, wie vorstehend beschrieben.

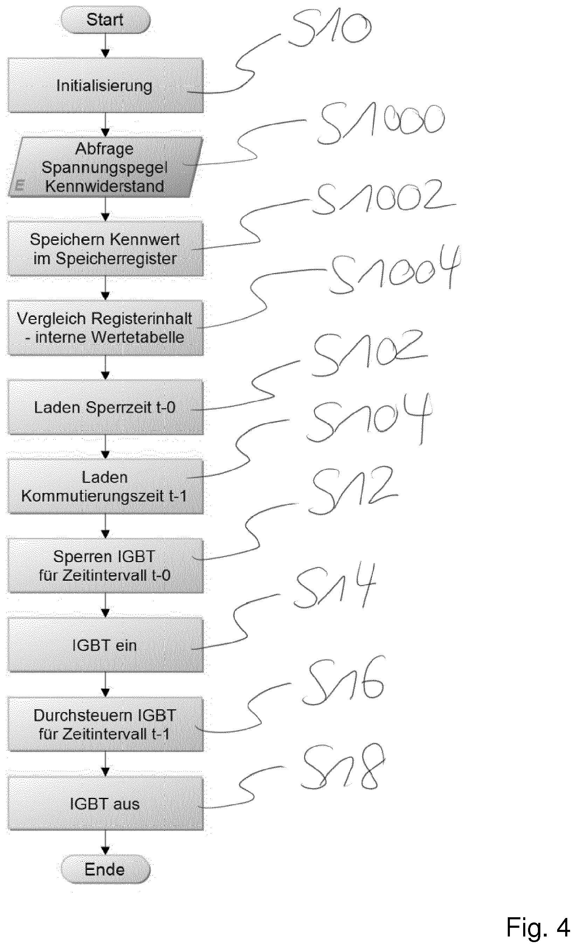

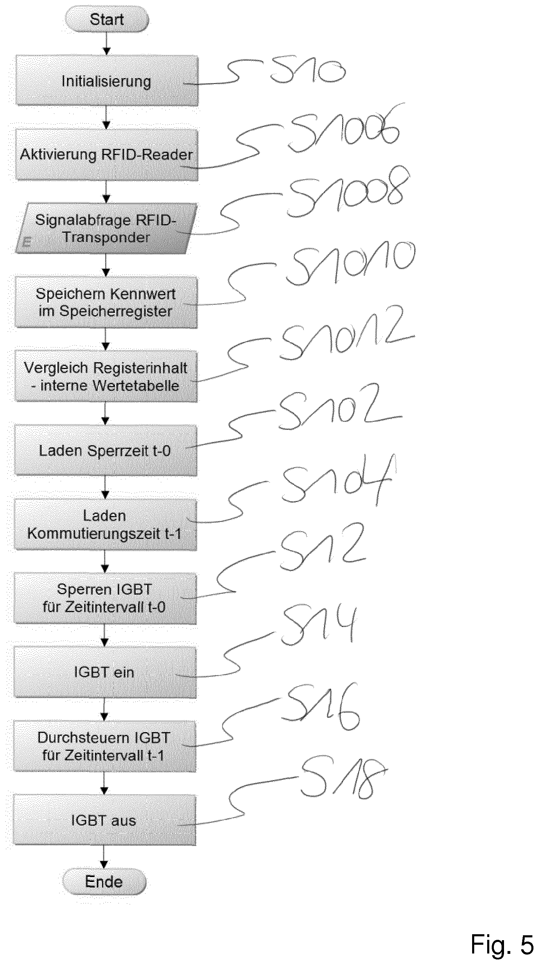

Die Daten 80 können auf verschiedene Arten empfangen werden, wie nachfolgend unter Bezugnahme auf die in den Fig.4 und 5 dargestellten Ablaufdiagramme erläutert wird:
Bei einer Variante über eine Kabelverbindung (Ablaufdiagramm Fig. 4) kann über die (standardisierte) Schaltelektronik 50 eine individuelle Kennung der mechanischen Kontaktanordnung 10 in der Weise abgefragt werden, dass der Spannungsabfall über einen elektrischen Widerstand, der typenspezifisch verschieden ausfällt und sich an irgendeiner Stelle integriert im Schaltgerät befindet, gemessen wird (Schritt S1000). Dies kann z.B. über eine entsprechende Kabelverbindung erfolgen, welche entweder bei der Gerätemontage angebracht wird, oder auch über eine Pin-Kontaktierung, welche z.B. bei der Assemblierung zweier Gehäuseteile automatisch erfolgt.

Eine andere Variante nutzt eine drahtlose Ausführung, z.B. durch Anregung eines RFID-Transponderchips oder -Tags 100 (Ablaufdiagramm Fig. 5). Beim Schaltgerät kann ein solcher RFID-Tag 100 in irgendeinem Gehäuseteil integriert sein. Das "Lesegerät" kann beispielsweise ein Teil der Schaltelektronik 50, beispielsweise in diese integriert sein. Nach erfolgter Einschaltinitialisierung und Aktivierung des Lesegeräts (Schritt S1006) sendet das Lesegerät der Schaltelektronik 50 magnetische Wechselfelder aus, welche den Transponder-Chip zunächst mit Energie versorgen und ihn dann zur Emission seiner individuellen Kennung anregen, welche von der Ansteuerelektronik gelesen wird (Schritt S1008).

Die Daten können auch beispielsweise durch individuelle Vorcodierung der Elektronik oder auch durch Codierung der Betriebssoftware z.B. während der Gerätemontage festgelegt werden, und dann bei der Initialisierung der Schaltelektronik 50 von dieser intern empfangen werden.

Die von der Schaltelektronik 50 empfangenen Daten werden in einem Register als Kennwert der mechanischen Kontaktanordnung 10 gespeichert (Schritt S1002 in Fig. 4, Schritt S1010 in Fig. 5). Das Register kann beispielsweise ein nichtflüchtiger Speicher insbesondere der Schaltelektronik 50 sein, so dass nicht jedes Mal bei der Initialisierung der Schaltelektronik 50 die Daten 80 empfangen werden müssen, sondern direkt aus dem Register ausgelesen werden können.

In der Betriebssoftware der Schaltelektronik 50 kann eine Wertetabelle mit Eigenschaften verschiedener mechanischer Kontaktanordnungen hinterlegt sein. Die hinterlegten Eigenschaften können beispielsweise Trägheitszeiten der mechanischen Kontaktanordnungen umfassen, anhand derer passende Sperrzeiten für den Halbleiterschalter 20 ermittelt werden können. Es können aber auch für die verschiedenen mechanischen Kontaktanordnungen bereits vorgegebene Sperrzeiten in der Wertetabelle hinterlegt sein. Insbesondere kann in der Wertetabelle mehreren Kontaktanordnungsvarianten jeweils eine entsprechende Sperrzeit bis zum Durchschalten des Halbleiterschalters 20 kurz vor einer mechanischen Kontaktierung zugeordnet sein. Die erste vorgegebene Zeitdauer t-0 wird dann von der Schaltelektronik 50 abhängig von der anhand der Wertetabelle ermittelten Sperrzeit eingestellt, insbesondere indem der im Register gespeicherte Kennwert mit den in der Wertetabelle gespeicherten Werten verglichen wird (Schritt S1004 in Fig. 4, Schritt S1012 in Fig. 5), und insbesondere abhängig vom Vergleich eine entsprechende vorgegebene erste Zeitdauer t-0 z.B. aus der Wertetabelle geladen bzw. eingestellt wird (Schritt S102). Die eingestellte vorgegebene Zeitdauer t-0 kann dann beispielsweise in einem nichtflüchtigen Speicher insbesondere Schaltelektronik 50 gespeichert werden, der während der Initialisierung der Schaltelektronik 50 ausgelesen werden kann. Danach kann insbesondere aus der Wertetabelle noch die vorgegebene zweite Zeitdauer t-1 geladen werden (Schritt S104), welche die Zeitdauer für das Anschalten bzw. Durchsteuern des Halbleiterschalters 20 bestimmt. Diese zweite vorgegebene Zeitdauer t-1 kann abhängig von der ersten mechanischen Kontaktanordnung 10, ggf. auch vom eingesetzten Halbleiterschalter 20, insbesondere abhängig von dessen Strombelastbarkeit, eingestellt werden.

Im Hinblick auf eine möglichst hohe elektrische Lebensdauer der IGBTs sowie auf deren vertretbar große Dimensionierung ist es zweckmäßig, den Stromfluss durch den Halbleiterschalter 20 zeitlich in der Weise zu begrenzen, dass der Strom dort nur so lange fließt, bis die mechanische Schaltstrecke eine ausreichende Wiederverfestigung erreicht hat. Für die Minimierung der Stromflusszeit durch den Halbleiterschalter 20 ist die genaue Kenntnis des Kommutierungszeitpunkts wichtig, da bei jedem Schaltgerät die effektiven Zeiten für den mechanischen Anschaltvorgang aus verschiedenen Gründen schwanken.

Der Zeitpunkt der Kommutierung auf den bereits durchgesteuerten IGBT des Halbleiterschalters 20 kann durch einen dort befindlichen Stromwandler 60 erfasst werden. Der Stromwandler 60 erzeugt ein Signal, sobald durch die IGBTs des Halbleiterschalters 20 ein Strom zu fließen beginnt, der Stromfluss also von der ersten mechanischen Kontaktanordnung 10 auf den Halbleiterschalter 20 kommutiert. Das vom Stromwandler 60 erzeugte und die Kommutierung signalisierende Signal wird der Schaltelektronik 50 zugeführt, die davon abhängig den Halbleiterschalter 20 wie im Folgenden beschrieben ansteuern kann.

Unmittelbar nach erfolgter Kommutierung kann die Schaltelektronik 50 den Halbleiterschalter 20 in der Weise ansteuern, dass die IGBTs des Halbleiterschalters 20 nach kurzer, über die Schaltelektronik 50 definierter bzw. vorgegebener Stromflusszeit bzw. Stromleitzeit wieder sperrend werden, so dass der kommutierte Laststrom im Halbleiterschalter 20 innerhalb der definierten Zeitdauer zu null geführt wird. Die Stromflusszeit ist idealerweise über die Schaltelektronik 50 so bemessen, dass die Schaltstrecke mit der ersten und zweiten mechanischen Kontaktanordnung 10 bzw. 30 vollständig geschlossen ist, d.h. die Schaltkontakte dauerhaft kontaktiert sind und eventuelle Schaltprellvorgänge nicht mehr auftreten.

Durch die Ausstattung des Halbleiterschalters 20 mit einem antiseriellen IGBT ist eine solche Schaltanordnung sowohl für DC-Ströme mit beliebiger Stromflussrichtung als auf für Wechselspannungen unterschiedlicher Frequenz einsetzbar, wobei der Schaltzeitpunkt aufgrund der unabhängigen Versorgung des Ansteuermoduls nicht phasenwinkelabhängig ist.

Während des Abschaltvorgangs im Halbleiterschalter 20 kommt es bei hohen Strömen zu hohen dl/dt-Werten, wodurch Spannungsspitzen deutlich oberhalb 1 kV entstehen können. Zum Schutz vor solchen Spannungsspitzen ist es zweckmäßig, dem Halbleiterschalter 20 ein Schutzorgan, z.B. in Form eines Varistors 70 vorzuschalten oder parallel zu schalten.

Die vorliegende Erfindung eignet sich insbesondere zum Einsatz in Schützen, Leistungsschaltern und Motorschutzschaltern, die insbesondere für einen Betrieb mit Gleichströmen und/oder niederfrequenten Strömen ausgelegt sind. Sie ermöglicht das Schalten von hohen Gleichströmen und niederfrequenten Strömen bei einer vergleichsweise hohen elektrischen Lebensdauer, da lange Lichtbogenbrenndauern ebenso wie eine lange Strombelastung des Halbleiterschalters vermieden werden können. Weiterhin gestatten diese Eigenschaften die Realisierung von vergleichsweise kompakten Schaltgeräten für hohe Ströme.

### Bezugszeichen

- 10: erste mechanische Kontaktanordnung
- 20: Halbleiterschalter
- 30: zweite mechanische Kontaktanordnung
- 40: galvanisch getrennte Hilfsspule
- 45a: erste Halbspule
- 45b: zweite Halbspule
- 46: U-förmiger Magnetkern
- 50: Schaltelektronik
- 60: Stromwandler
- 70: Varistor
- 80: Daten zur ersten mechanischen Kontaktanordnung
- 90: Stromversorgung der Schaltelektronik
- 100: RFID-Transponderchip

## Patentansprüche

1. Schaltvorrichtung zum Führen und Trennen von elektrischen Strömen mit
- einer ersten mechanischen Kontaktanordnung (10),
- einem Halbleiterschalter (20), der parallel zur ersten mechanischen Kontaktanordnung geschaltet ist,
- einer zweiten mechanischen Kontaktanordnung (30), die in Reihe zur ersten mechanischen Kontaktanordnung geschaltet ist, und
- einer Schaltelektronik (50), die zum An- und Abschalten des Halbleiterschalters (20) ausgebildet ist,
**dadurch gekennzeichnet, dass**
die Schaltelektronik (50) ausgebildet ist, während eines Schließvorgangs der ersten mechanischen Kontaktanordnung (10) den Halbleiterschalter (20) nach Ablauf einer ersten vorgegebenen Zeitdauer t-0 (S12) nach Initialisierung (S10) der Schaltelektronik (50) anzuschalten (S14) und nach Ablauf einer zweiten vorgegebenen Zeitdauer t-1 (S16) wieder auszuschalten (S18), wobei die erste vorgegebene Zeitdauer t-0 von der Schaltelektronik (50) abhängig von der ersten mechanischen Kontaktanordnung (10) eingestellt wird.

2. Schaltvorrichtung nach Anspruch 1,
**dadurch gekennzeichnet, dass**
die Schaltelektronik (50) ausgebildet ist, die zweite vorgegebene Zeitdauer t-1 abhängig von der ersten mechanischen Kontaktanordnung (10) einzustellen (S104).

3. Schaltvorrichtung nach Anspruch 1 oder 2,
**dadurch gekennzeichnet, dass**
die Schaltelektronik (50) ausgebildet ist, nach Initialisierung (S10) der Schaltelektronik (50) Daten (80) zur ersten mechanischen Kontaktanordnung (10) zu empfangen (S100) und abhängig von den empfangenen Daten (80) die erste vorgegebene Zeitdauer t-0 und/oder die zweite vorgegebene Zeitdauer t-1 einzustellen (S102, S104).

4. Schaltvorrichtung nach Anspruch 3,
**dadurch gekennzeichnet, dass**
die Schaltelektronik (50) ausgebildet ist, Daten (80) zur ersten mechanischen Kontaktanordnung (10) zu empfangen, indem sie
- den Spannungsabfall an einem der ersten mechanischen Kontaktanordnung (10) zugeordneten elektrischen Widerstand misst (S1000),
- den Messwert in einem Register als Kennwert speichert (S1002),
- anhand des Kennwerts und einer Wertetabelle mit Eigenschaften verschiedener mechanischer Kontaktanordnungen eine für die erste mechanische Kontaktanordnung (10) passende Sperrzeit für den Halbleiterschalter (10) ermittelt (S1004) und
- die erste vorgegebene Zeitdauer t-0 abhängig von der ermittelten Sperrzeit einstellt (S102).

5. Schaltvorrichtung nach Anspruch 2, 3 oder 4,
**dadurch gekennzeichnet, dass**
die Schaltelektronik (50) ausgebildet ist, Daten (80) zur ersten mechanischen Kontaktanordnung (10) zu empfangen, indem sie
- ein drahtloses Lesegerät aktiviert (S1006),
- mit dem aktivierten Lesegerät in einem der ersten mechanischen Kontaktanordnung (10) zugeordneten Transponder (100) gespeicherte Daten (80) ausliest (S1008),
- die ausgelesenen Daten (80) in einem Register als Kennwert speichert (S1010),
- anhand des Kennwerts und einer Wertetabelle mit Eigenschaften verschiedener mechanischer Kontaktanordnungen eine für die erste mechanische Kontaktanordnung (10) passende Sperrzeit für den Halbleiterschalter (10) ermittelt (S1012) und
- die erste vorgegebene Zeitdauer t-0 abhängig von der ermittelten Sperrzeit einstellt (S102).

6. Schaltvorrichtung nach Anspruch 4 oder 5,
**dadurch gekennzeichnet, dass**
die Schaltelektronik (50) ausgebildet ist,
- anhand des Kennwerts und der Wertetabelle mit Eigenschaften verschiedener mechanischer Kontaktanordnungen eine für die erste mechanische Kontaktanordnung (10) passende Kommutierungszeit zu ermitteln (S1004; S1012) und
- die zweite vorgegebene Zeitdauer t-1 abhängig von der ermittelten Kommutierungszeit einzustellen (S104).

7. Schaltgerät mit
- einer Schaltvorrichtung nach einem der vorhergehenden Ansprüche und
- einem Schaltantrieb zum Bewegen von Kontakten der ersten und zweiten mechanischen Kontaktanordnung.

8. Schaltgerät nach Anspruch 7, das ein Gehäuse aufweist, das mindestens ein elektronisches Bauelement und/oder elektrische Kontaktmittel aufweist, das bzw. die vorgesehen sind, um von einer Schaltelektronik (50) einer Schaltvorrichtung des Schaltergeräts zum Einstellen der ersten vorgegebenen Zeitdauer t-0 verwendet zu werden.

9. Verfahren zum Steuern eines Halbleiterschalters (20) einer Schaltvorrichtung zum Führen und Trennen von elektrischen Strömen, die eine erste mechanische Kontaktanordnung (10), den Halbleiterschalter (20), der parallel zur ersten mechanischen Kontaktanordnung geschaltet ist, und eine zweite mechanische Kontaktanordnung (30) aufweist, die in Reihe zur ersten mechanischen Kontaktanordnung geschaltet ist,
**dadurch gekennzeichnet, dass**
bei dem Verfahren der Halbleiterschalter (20) während eines Schließvorgangs der ersten mechanischen Kontaktanordnung (10) nach Ablauf einer ersten vorgegebenen Zeitdauer t-0 (S12) nach Initialisierung (S10) einer zum An- und Abschalten des Halbleiterschalters (20) ausgebildeten Schaltelektronik (50) angeschaltet (S14) und nach Ablauf einer zweiten vorgegebenen Zeitdauer t-1 (S16) wieder ausgeschaltet (S18) wird, wobei die erste vorgegebene Zeitdauer t-0 von der Schaltelektronik (50) abhängig von der ersten mechanischen Kontaktanordnung (10) eingestellt wird (S100, S102).

10. Verfahren nach Anspruch 9, **dadurch gekennzeichnet, dass** es von der zum An- und Abschalten des Halbleiterschalters (20) ausgebildeten Schaltelektronik (50) ausgeführt wird, wobei die Schaltelektronik (50) insbesondere durch einen Prozessor und einen Speicher implementiert ist, in dem ein Programm gespeichert ist, das den Prozessor zum Ausführen eines Verfahrens nach Anspruch 9 konfiguriert.

## Claims

1. Switching device for conducting and interrupting electrical currents, having
- a first mechanical contact assembly (10),
- a semiconductor switch (20) connected in parallel to the first mechanical contact assembly,
- a second mechanical contact assembly (30) connected in series to the first mechanical contact assembly, and
- a switching electronics system (50) designed to switch the semiconductor switch (20) on and off,
**characterised in that**
the switching electronics system (50) is designed, during a closing process of the first mechanical contact assembly (10), to switch on (S14) the semiconductor switch (20) at the end of a first specified time period t-0 (S12) after initialisation (S10) of the switching electronics system (50), and to switch same off (S18) again at the end of a second specified time period t-1 (S16), wherein the first specified time period t-0 is set by the switching electronics system (50) depending on the first mechanical contact assembly (10).

2. Switching device according to claim 1,
**characterised in that**
the switching electronics system (50) is designed to set (S104) the second specified time period t-1 depending on the first mechanical contact assembly (10).

3. Switching device according to claim 1 or 2,
**characterised in that**
the switching electronics system (50) is designed, after initialisation (S10) of the switching electronics system (50), to receive (S100) data (80) for the first mechanical contact assembly (10) and to set (S102, S104) the first specified time period t-0 and/or the second specified time period t-1 depending on the received data (80).

4. Switching device according to claim 3,
**characterised in that**
the switching electronics system (50) is designed to receive data (80) for the first mechanical contact assembly (10) by
- measuring (S1000) the voltage drop across an electrical resistance associated with the first mechanical contact assembly (10),
- storing (S1002) the measured value in a register as a characteristic value,
- determining (S1004) a suitable blocking time for the first mechanical contact assembly (10) for the semiconductor switch (10) based on the characteristic value and a value table that includes properties of various mechanical contact assemblies, and
- setting (S102) the first specified time period t-0 depending on the determined blocking time.

5. Switching device according to claim 2, 3 or 4,
**characterised in that**
the switching electronics system (50) is designed to receive data (80) for the first mechanical contact assembly (10) by
- activating (S1006) a wireless reading device,
- reading out (S1008) data (80) stored in a transponder (100) associated with the first mechanical contact assembly (10) using the activated reading device,
- storing (S1010) the read-out data (80) in a register as a characteristic value,
- determining (S1012) a suitable blocking time for the first mechanical contact assembly (10) for the semiconductor switch (10), based on the characteristic value and a value table that includes properties of various mechanical contact assemblies, and
- setting (S102) the first specified time period t-0 depending on the determined blocking time.

6. Switching device according to claim 4 or 5,
**characterised in that**
the switching electronics system (50) is designed
- to determine (S1004; S1012) a suitable commutation time for the first mechanical contact assembly (10), based on the characteristic value and a value table that includes properties of various mechanical contact assemblies, and
- to set (S104) the second specified time period t-1 depending on the determined commutation time.

7. Switching instrument having
- a switching device according to any of the preceding claims and
- a switching drive for moving contacts of the first and second mechanical contact assembly.

8. Switching instrument according to claim 7, which has a housing which has at least one electronic component and/or electrical contact means which is/are provided in order to be used by a switching electronics system (50) of a switching device of the switching instrument for setting the first specified time period t-0.

9. Method for controlling a semiconductor switch (20) of a switching device for conducting and interrupting electric currents, which switching device has a first mechanical contact assembly (10), the semiconductor switch (20) connected in parallel to the first mechanical contact assembly, and a second mechanical contact assembly (30) connected in series to the first mechanical contact assembly,
**characterised in that**
in the method, the semiconductor switch (20) is switched on (S14), during a closing process of the first mechanical contact assembly (10), at the end of a first specified time period t-0 (S12) after initialisation (S10) of a switching electronics system (50) designed to switch the semiconductor switch (20) on and off, and is switched off (S18) again at the end of a second specified time period t-1 (S16), wherein the first specified time period t-0 is set (S100, S102) by the switching electronics system (50) depending on the first mechanical contact assembly (10).

10. Method according to claim 9, **characterised in that** said method is performed by the switching electronics system (50), which is designed to switch the semiconductor switch (20) on and off, wherein the switching electronics system (50) is implemented in particular by a processor and a memory in which a program is stored that configures the processor to perform a method according to claim 9.

## Revendications

1. Dispositif de commutation permettant de laisser passer et de sectionner des courants électriques, avec
- une première structure de contact mécanique (10),
- un contacteur à semiconducteur (20) monté en parallèle par rapport à la première structure de contact mécanique,
- une seconde structure de contact mécanique (30) montée en série par rapport à la première structure de contact mécanique, et
- une électronique de commutation (50) conçue pour connecter et déconnecter le contacteur à semiconducteur (20),
**caractérisé en ce que**
l'électronique de commutation (50) est conçue pour, pendant une opération de fermeture de la première structure de contact mécanique (10), connecter (S14) le contacteur à semiconducteur (20) après écoulement d'une première durée t-0 (S12) prédéfinie après initialisation (S10) de l'électronique de commutation (50) et pour le déconnecter (S18) à nouveau après écoulement d'une seconde durée t-1 (S16) prédéfinie, dans lequel la première durée t-0 prédéfinie est ajustée par l'électronique de commutation (50) en fonction de la première structure de contact mécanique (10).

2. Dispositif de commutation selon la revendication 1,
**caractérisé en ce que**
l'électronique de commutation (50) est conçue pour ajuster (S104) la seconde durée t-1 prédéfinie en fonction de la première structure de contact mécanique (10).

3. Dispositif de commutation selon la revendication 1 ou 2,
**caractérisé en ce que**
l'électronique de commutation (50) est conçue pour recevoir (S100) des données (80) concernant la première structure de contact mécanique (10) après initialisation (S10) de l'électronique de commutation (50) et, en fonction des données (80) reçues, ajuster (S102, S104) la première durée t-0 prédéfinie et/ou la seconde durée t-1 prédéfinie.

4. Dispositif de commutation selon la revendication 3,
**caractérisé en ce que**
l'électronique de commutation (50) est conçue pour recevoir des données (80) concernant la première structure de contact mécanique (10) grâce à
- une mesure (S1000) de la chute de tension au niveau d'une résistance électrique associée à la première structure de contact mécanique (10),
- un stockage (S1002) de la valeur de mesure sous forme de valeur caractéristique dans un registre,
- une détermination (S1004), à l'aide de la valeur caractéristique et d'un tableau de valeurs comprenant des propriétés de différentes structures de contact mécaniques, d'un temps de blocage, adapté à la première structure de contact mécanique (10), pour l'interrupteur à semiconducteur (10) et
- un ajustement (S102) de la première durée t-0 prédéfinie en fonction du temps de blocage déterminé.

5. Dispositif de commutation selon la revendication 2, 3 ou 4,
**caractérisé en ce que**
l'électronique de commutation (50) est conçue pour recevoir des données (80) concernant la première structure de contact mécanique (10) grâce à
- une activation (S1006) d'un appareil de lecture sans fil,
- une lecture (S1008), par l'appareil de lecture activé, de données (80) stockées dans un transpondeur (100) associé à la première structure de contact mécanique (10),
- un stockage (S1010), sous forme de valeur caractéristique, des données (80) lues dans un registre,
- une détermination (S1012), à l'aide de la valeur caractéristique et d'un tableau de valeurs comprenant des propriétés de différentes structures de contact mécaniques, d'un temps de blocage, adapté à la première structure de contact mécanique (10), pour l'interrupteur à semiconducteur (10) et
- un ajustement (S102) de la première durée t-0 prédéfinie en fonction du temps de blocage déterminé.

6. Dispositif de commutation selon la revendication 4 ou 5,
**caractérisé en ce que**
l'électronique de commutation (50) est conçue,
- pour déterminer (S1004 ; S1012), à l'aide de la valeur caractéristique et du tableau de valeurs comprenant des propriétés de différentes structures de contact mécaniques, un temps de commutation adapté à la première structure de contact mécanique (10) et
- ajuster (S104) la seconde durée t-1 prédéfinie en fonction du temps de commutation déterminé.

7. Appareil de commutation, avec
- un dispositif de commutation selon l'une quelconque des revendications précédentes et
- un entraînement de commutation permettant de déplacer des contacts des première et seconde structures de contact mécaniques.

8. Dispositif de commutation selon la revendication 7, présentant un boîtier qui présente au moins un composant électronique et/ou un organe de contact électrique, qui est/sont prévu(s) pour être utilisé(s) par une électronique de commutation (50) d'un dispositif de commutation de l'appareil de commutation pour ajuster la première durée t-0 prédéfinie.

9. Procédé de commande d'un contacteur à semi-conducteur (20) d'un dispositif de commutation permettant de laisser passer et de sectionner des courants électriques, qui présente une première structure de contact mécanique (10), le contacteur à semiconducteur (20) monté en parallèle par rapport à la première structure de contact mécanique, et une seconde structure de contact mécanique (30) montée en série par rapport à la première structure de contact mécanique,
**caractérisé en ce que**
dans le présent procédé, le contacteur à semi-conducteur (20), pendant une opération de fermeture de la première structure de contact mécanique (10), est connecté (S14) après écoulement d'une première durée t-0 (S12) prédéfinie après initialisation (S10) d'une électronique de commutation (50) conçue pour connecter et déconnecter le contacteur à semi-conducteur (20) et est déconnecté (S18) à nouveau après écoulement d'une seconde durée t-1 (S16) prédéfinie, dans lequel la première durée t-0 prédéfinie est ajustée (S100, S102) par l'électronique de commutation (50) en fonction de la première structure de contact mécanique (10).

10. Procédé selon la revendication 9, **caractérisé en ce qu'**il est mis en œuvre par l'électronique de commutation (50) conçue pour connecter et déconnecter le contacteur à semiconducteur (20), dans lequel l'électronique de commutation (50) est en particulier implémentée grâce à un processeur et une mémoire au sein de laquelle est stocké un programme qui configure le processeur afin de mettre en œuvre un procédé selon la revendication 9.
